# EUROPÄISCHE PATENTSCHRIFT

(11) **EP 0 535 413 B1**
(45) Veröffentlichungstag und Bekanntmachung des Hinweises auf die Patenterteilung: **06.12.1995**
(21) Anmeldenummer: 92115415.9
(22) Anmeldetag: 09.09.1992
(51) Int. Cl.: C23C 14/02, C23C 14/18

(54) **Verfahren zur Herstellung eines haftfesten Verbundes von Kupferschichten und Aluminiumoxidkeramik ohne Einsatz von Haftvermittlern**
Method for producing an adhesive-stable joint of layers of copper with alumina-ceramics without use of agent mediating the bond
Procédé pour la formation d'une jonction adhérente de couches de cuivre à une céramique d'alumine sans utilisation d'un agent adhésif

(30) Priorität: 13.09.1991 DE 4130518
(43) Veröffentlichungstag der Anmeldung: 07.04.1993
(73) Patentinhaber: HOECHST AKTIENGESELLSCHAFT, 65926 Frankfurt am Main (DE)
(72) Erfinder: Hoffmann, Bernard, Dr., W-6380 Bad Homburg (DE); Gernoth, Hartwig, W-6806 Viernheim (DE)

(56) Entgegenhaltungen:
- EP-A- 0 351 533
- DE-A- 3 036 128
- DE-A- 3 824 249
- PATENT ABSTRACTS OF JAPAN, unexamined applications, C Sektion, Band 12, Nr. 372, 5. Oktober 1988, THE PATENT OFFICE JAPANESE GOVERNMENT, Seite 72 C 533
- PATENT ABSTRACTS OF JAPAN, unexamined applications, C Sektion, Band 13, Nr. 63, 13. Februar 1989, THE PATENT OFFICE JAPANESE GOVERNMENT, Seite 53 C 568

## Beschreibung

Die Erfindung betrifft ein Verfahren zur Herstellung eines haftfesten Verbundes Von Kupferschichten, die mittels Sputtertechnik aufgebracht sind, und Aluminiumoxidkeramik.

Auf dem Gebiet der elektronischen Bauelemente ist die Verbindung von Kupfer als elektrisch sehr gut leitendem Metall mit Aluminiumoxidkeramik als gut wärmeleitendem Isolator von besonderer technischer Bedeutung. Die Kupferschicht findet Verwendung als Leiterbahnschicht, Elektrodenschicht, Sensorschicht oder auch als Verbindungsschicht beim Anlöten der Aluminiumoxidkeramik als Kühlkörper ("Heatsink") an andere Wärme entwickelnde Bauteile.

Für das direkte Aufbringen von Kupfer auf die Keramik sind im Prinzip zwei verschiedene Verfahren bekannt. Die DE-A-38 24 249 beschreibt die außenstromlose Abscheidung nach vorheriger Aufrauhung der Keramikoberfläche und die anschließende Palladiumbekeimung mit nachfolgender Wärmebehandlung, während in der DE-A-30 36 128 das sogenannte Direct-Copper-Bonding Verfahren (DCB) angegeben ist, bei dem ein 100 bis 900 »m dickes Kupferblech bei ca. 1070 °C auf die Keramikoberfläche aufgebracht wird. Beide Verfahren sind technisch aufwendig und darüber hinaus wegen der notwendigen Aufrauhung der Keramik bzw. wegen der Dicke der Kupferschicht für die Herstellung von Kupferstrukturen mit einer Geometrie hoher Exaktheit nicht geeignet. Auch für die Anwendung in der Hochfrequenztechnik sind die nach den bekannten Verfahren hergestellten Verbunde aus Keramik und Kupfer nur sehr beschränkt einsetzbar.

Deshalb ist man häufig dazu übergegangen, die Grundmetallisierung durch die Methode der Kathodenzerstäubung im Vakuum (= Sputtertechnik) aufzubringen.

Es ist jedoch seit langem bekannt, daß mit dieser Technik auf Keramik aufgebrachtes Kupfer nur sehr unzureichende Haftfestigkeiten erreicht. Aus diesem Grund ist es seit Jahren Stand der Technik, zwischen Keramik und Kupfer sputtertechnisch eine einige 10 bis 100 nm dünne sogenannte Haftvermittlerschicht bestehend aus einem Reaktivmetall aufzubringen. Als Haftvermittler dienen üblicherweise Metalle wie Chrom, Titan, Nickel, Tantal, Wolfram oder Legierungen wie TiW oder NiCr. Obwohl mit diesen metallischen Haftvermittlern ausgezeichnete Haftwerte von 50 MPa und mehr erreicht werden hat diese Technik zwei entscheidende Nachteile. Erstens müssen in der Sputterbeschichtungsanlage zwei getrennt ansteuerbare Targets vorhanden sein, nämlich Haftvermittler und Kupfer, und zweitens ist bei der späteren Strukturierung der Metallschicht ein zusätzlicher Ätzschritt notwendig, weil sich keiner der Haftvermittler mit einem für Kupfer geeigneten Ätzmedium strukturieren läßt. Ein weiterer Nachteil ist darin zu sehen, daß die Ätzmedien für die Haftvermittler meistens sehr aggressiv und damit besonders im Produktionsmaßstab sehr schwierig handhabbar sind.

Patent Abstracts of Japan, Vol. 13, No. 63, 53 C 568 und JP-A-63 255 360 beschreiben ein Verfahren, bei dem ein Metall auf eine Keramikoberfläche aufgedampft wird und bei dem die Haftung durch simultanen Ionenbeschuß erzeugt wird. Die hierdurch hergestellte metallische Beschichtung enthält auch die durch Ionenbeschuß eingebrachten Ionen, zum Beispiel von Argon oder Stickstoff.

Aufgabe der Erfindung war es, elementares Kupfer sputtertechnisch haftfest auf Aluminiumoxidkeramik aufzubringen, ohne daß hierfür eine zusätzliche Haftvermittlerzwischenschicht benötigt wird.

Gelöst wird diese Aufgabe durch ein Verfahren gemäß Patentanspruch 1, dessen nähere Ausgestaltungen in den darauf zurückbezogenen Patentansprüchen 2 bis 10 angegeben sind.

Unter einem Plasmaätzprozeß soll erfindungsgemäß verstanden werden, daß eine hochfrequente Gasentladung über den Substraten gezündet wird. Vorzugsweise wird die Keramik vor der Plasmaätzung einem Reinigungsverfahren, insbesondere in Isopropanol im Ultraschallbad oder in heißer Schwefelsäure beispielsweise bei 160 °C unterzogen, um eventuell vorhandene organische Verunreinigungen an der Oberfläche zu entfernen. Nach einer Trocknung bei Temperaturen von etwa 200 °C wird das Keramiksubstrat in eine Vakuumkammer eingeschleust, die mit einer Vorrichtung zum Plasmaätzen ausgestattet ist. Die Kammer wird auf etwa 10⁻³ Pa evakuiert, dann wird als Prozeßgas Sauerstoff oder Argon eingelassen, so daß sich in der Kammer ein Gleichgewichtsdruck von etwa 1 Pa einstellt. Danach wird eine hochfrequente Gasentladung über den Substraten gezündet. Erfindungsgemäß werden die besten Haftfestigkerten erzielt, wenn diese Plasmaätzung über eine Zeitspanne im Bereich von 15 und 30 Minuten in Sauerstoff bei einer Leistungsdichte von circa 0,6 W/cm stattfindet. Es werden aber auch bei geringerer Leistung und mit dem Prozeßgas Argon gute Haftfestigkeiten erzielt, wenn die Plasmaätzung über eine Zeitdauer von wenigstens 15 Minuten durchgeführt wird.

Der Ausdruck "danach sofort" bedeutet im Rahmen der vorliegenden Erfindung, daß die plasmageätzte Oberfläche zwischen der Plasmaätzung und dem Aufsputterprozeß nicht mit Luft oder anderen störenden Gasen in Berührung kommt. Das plasmageätzte Substrat wird deshalb unmittelbar nach dem Plasmaätzprozeß in eine zweite, sich direkt anschließende Vakuumkammer geschleust, in der die sputtertechnische Kupferbeschichtung stattfindet. Das Grundvakuum in dieser Kammer beträgt bevorzugt 10⁻⁵ Pa, das Kupfer kann in Schichtdicken von 100 nm bis zu 10 »m aufgesputtert werden, wobei die Prozeßparameter des Cu-Sputterns allgemein bekannt sind, in der Praxis hat sich eine dynamische Beschichtung unter einem Argondruck von 1 Pa und bei einer Abscheidungsrate von etwa 0,25-0,5 »m/min am besten bewährt.

Durch den Einsatz des ausführlich beschriebenen Plasmaätzprozeßes lassen sich erfindungsgemäß Haftfestigkeiten von bis zu ca. 50 MPa, gemessen durch Stirnabzugsversuch in Anlehnung an DIN 50160, erzielen. Dieses Ergebnis übersteigt die für die eingangs genannten Anwendungsgebiete geforderten Haftfestigkeiten (meist > 30 MPa) bei weitem.

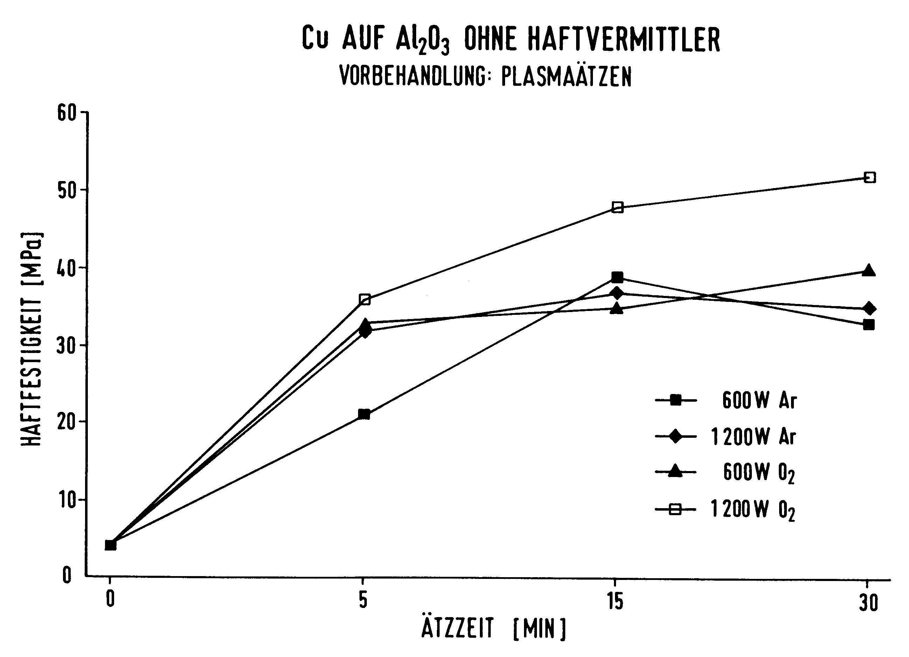

Die Erfindung soll beispielhaft anhand der beigefügten Figur noch deutlicher erläutert werden. Die Figur stellt in einem Diagramm dar, wie sich in Abhängigkeit von der Ätzzeit, der Ätzleistung und der Atmosphäre Haftfestigkeiten von Kupfer auf Aluminiumoxidsubstraten im Bereich von 30 bis 52 MPa erreichen lassen.

Nach der erfindungsgemäßen Grundmetallisierung der Aluminiumoxidkeramik mit Kupfer ohne Haftvermittler kann - falls erforderlich - der weitere galvanische Aufbau der Kupferschicht und/oder die Strukturierung der Leiterbahn-, Elektroden-, Sensor- oder Lötgrundschichten nach den allgemein bekannten Verfahren erfolgen. Hierfür kommen insbesondere in Frage:
- Die direkte Strukturierung mittels Photoresisttechnik, falls die Sputterschicht eine ausreichende Dicke von wenigstens 300 nm hat.
- Die direkte Strukturierung mittels Lasertechnik, falls die Sputterschicht eine ausreichende Dicke von wenigstens 300 nm hat.
- Vollflächiger galvanischer Aufbau auf die gewünschte Schichtdicke und anschließende Strukturierung mittels Lasertechnik.
- Vollflächiger galvanischer Aufbau auf die gewünschte Schichtdicke und anschließende Strukturierung mittels Photoresisttechnik ("Subtraktivtechnik").
- Bebilderung mit Photoresist, galvanischer Aufbau, Strippen des Photoresist und Differenzätzen ("Semiadditivtechnik").

Allen Verfahren gemeinsam ist, daß bei der erfindungsgemäßen Technik zur Kupferbeschichtung im Rahmen der nachfolgenden bestimmungsgemäßen Strukturierung kein separater Ätzschritt zur Entfernung eines Haftvermittlers mehr notwendig ist.

## Patentansprüche

1. Verfahren zur Herstellung eines haftfesten Verbundes von Kupferschichten, die mittels Sputtertechnik aufgebracht sind, und Aluminiumoxidkeramik, dadurch gekennzeichnet, daß die Aluminiumoxidoberfläche zunächst einem Plasmaätzprozess im Vakuum bei einer Leistungsdichte von 0,2 bis 1,0 W/cm unterzogen wird und daß die plasmageätzte Oberfläche unmittelbar nach dem Plasmaätzprozess unter Luftausschluß in eine Vakuumkammer geschleust und sputtertechnisch mit Kupfer beschichtet wird.

2. Verfahren nach Anspruch 1, dadurch gekennzeichnet, daß für den Plasmaätzprozeß eine hochfrequente Gasentladung über der Aluminiumoxidoberfläche gezündet wird.

3. Verfahren nach Anspruch 1 oder 2, dadurch gekennzeichnet, daß die Keramik vor der Plasmaätzung einem Reinigungsverfahren unterzogen wird.

4. Verfahren nach Anspruch 3, dadurch gekennzeichnet, daß das Reinigungsverfahren mit Isopropanol im Ultraschallbad durchgeführt wird.

5. Verfahren nach Anspruch 3, dadurch gekennzeichnet, daß das Reinigungsverfahren in heißer Schwefelsäure bei Temperaturen im Bereich von 120 bis 180 °C durchgeführt wird.

6. Verfahren nach einem der Ansprüche 3 bis 5, dadurch gekennzeichnet, daß die Keramik nach dem Reinigungsverfahren einer Trocknung bei Temperaturen von etwa 200 °C unterzogen wird.

7. Verfahren nach Anspruch 6, dadurch gekennzeichnet, daß das Keramiksubstrat nach der Trocknung in eine Vakuumkammer eingeschleust wird, die mit einer Vorrichtung zum Plasmaätzen ausgestattet ist, und daß die Kammer auf etwa 10⁻³ Pa evakuiert wird.

8. Verfahren nach Anspruch 7, dadurch gekennzeichnet, daß als Prozeßgas Sauerstoff oder Argon in die Kammer eingelassen wird, so daß sich in der Kammer ein Gleichgewichtsdruck von 0,1 bis 3 Pa, vorzugsweise von 0,5 bis 2 Pa, einstellt.

9. Verfahren nach einem der Ansprüche 3 bis 8, dadurch gekennzeichnet, daß eine hochfrequente Gasentladung über den Substraten gezündet wird.

10. Verfahren nach einem der Ansprüche 1 bis 9, dadurch gekennzeichnet, daß die Plasmaätzung über einen Zeitraum im Bereich von 15 bis 30 Minuten und bei einer Leistungsdichte von 0,4 bis 0,8 W/cm stattfindet.

11. Verwendung eines Verfahrens nach einem der Ansprüche 1 bis 10 zur Erzeugung von Haftfestigkeiten von wenigstens 30 MPa, vorzugsweise im Bereich von 35 bis 50 MPa, gemessen durch Stirnabzugsversuch in Anlehnung an DIN 50160.

## Claims

1. A process for producing a firm bond between copper layers applied by sputtering and aluminum oxide ceramic, which comprises first subjecting the aluminum oxide surface to a plasma etching process in a vacuum at a power density of from 0.2 to 1.0 W/cm and immediately following the plasma etching process introducing the plasma etched surface into a vacuum chamber with exclusion of air and coating it with copper by sputtering.

2. The process of claim 1, wherein the plasma etching process comprises striking a high frequency gas discharge above the aluminum oxide surface.

3. The process of claim 1 or 2, wherein the ceramic is subjected to a cleaning process prior to the plasma etching.

4. The process of claim 3, wherein the cleaning process is carried out with isopropanol in an ultrasonic bath.

5. The process of claim 3, wherein the cleaning process is carried out in hot sulfuric acid at temperatures within the range from 120 to 180°C.

6. The process of any one of claims 3 to 5, wherein the ceramic is subjected to drying at temperatures of about 200°C following the cleaning process.

7. The process of claim 6, wherein, after drying, the ceramic substrate is introduced into a vacuum chamber fitted with a plasma etching apparatus and the chamber is evacuated down to about 10⁻³ Pa.

8. The process of claim 7, wherein oxygen or argon is introduced into the chamber as process gas so that the chamber comes to an equilibrium pressure of from 0.1 to 3 Pa, preferably of from 0.5 to 2 Pa.

9. The process of any one of claims 3 to 8, wherein a high frequency gas discharge is struck above the substrates.

10. The process of any one of claims 1 to 9, wherein the plasma etching takes place over a period within the range from 15 to 30 minutes and at a power density of from 0.4 to 0.8 W/cm.

11. The use of a process as claimed in any one of claims 1 to 10 for generating adhesive strengths of at least 30 MPa, preferably within the range from 35 to 50 MPa, measured by perpendicular peeling on the line of German Standard Specification DIN 50160.

## Revendications

1. Procédé de préparation d'une jonction adhérente entre des couches de cuivre, déposées au moyen de la technique de métallisation par pulvérisation ou vaporisation ("sputtertechnik"), et une céramique d'alumine, caractérisé en ce que la surface d'alumine est soumise d'abord à un procédé de décapage au plasma sous vide sous une densité de puissance comprise entre 0,2 et 1,0 W/cm et la surface décapée au plasma est isolée, immédiatement après le procédé de décapage au plasma, de l'air ambiant en étant placée dans une chambre à vide et est enduite avec du cuivre selon la technique de métallisation par pulvérisation ou vaporisation.

2. Procédé selon la revendication 1, caractérisé en ce qu'on amorce une décharge gazeuse à haute fréquence sur la surface d'alumine dans le procédé de décapage au plasma.

3. Procédé selon la revendication 1 ou 2, caractérisé en ce qu'on soumet la céramique à un procédé de purification avant d'entreprendre le décapage au plasma.

4. Procédé selon la revendication 3, caractérisé en ce que le procédé de purification est réalisé avec de l'isopropanol dans un bain à ultrasons.

5. Procédé selon la revendication 3, caractérisé en ce que le procédé de purification est réalisé avec de l'acide sulfurique chauffé à des températures comprises entre 120 et 180 °C.

6. Procédé selon l'une des revendications 3 à 5, caractérisé en ce que la céramique est soumise à un séchage à des températures d'environ 200°C après avoir réalisé le procédé de purification.

7. Procédé selon la revendication 6, caractérisé en ce que le substrat en céramique est isolé après le séchage dans une chambre à vide, munie d'un dispositif de décapage au plasma, et la chambre est mise sous vide à environ 10⁻³ Pa.

8. Procédé selon la revendication 7, caractérisé en ce que on fait entrer dans la chambre de l'oxygène ou de l'argon tant que gaz intervenant dans le processus, de sorte que la pression d'équilibre dans la chambre s'établisse entre 0,1 et 3 Pa, de préférence entre 0,5 et 2 Pa.

9. Procédé selon l'une des revendications 3 à 8, caractérisé en ce qu'on amorce une décharge gazeuse à haute fréquence sur les substrats.

10. Procédé selon l'une des revendications 1 à 9, caractérisé en ce que le décapage au plasma se fait dans un espace de temps compris entre 15 et 30 minutes et à une densité de puissance comprise entre 0,4 et 0,8 W/cm.

11. Utilisation d'un procédé selon l'une des revendications 1 à 10, afin de générer une force d'adhésion d'au moins 30 MPa, de préférence comprise entre 35 et 50 MPa, mesurée par des essais de traction ou arrachement frontal en s'appuyant sur la norme DIN 50160.
